# EUROPEAN PATENT SPECIFICATION

(11) **EP 4 318 728 B1**
(45) Date of publication and mention of the grant of the patent: **15.07.2026**
(21) Application number: 22881233.5
(22) Date of filing: 20.09.2022
(51) Int. Cl.: H01M 10/42, H01M 10/48, G01R 31/371, G01R 31/385

(54) **BATTERY CONTROL SYSTEM AND METHOD FOR GUIDING SOC LEVEL**
BATTERIESTEUERUNGSSYSTEM UND VERFAHREN ZUR FÜHRUNG DES SOC-NIVEAUS
SYSTÈME DE COMMANDE DE BATTERIE ET PROCÉDÉ DE GUIDAGE DE NIVEAU DE SOC

(30) Priority: 15.10.2021 KR 20210137911
(43) Date of publication of application: 07.02.2024
(73) Proprietor: LG Energy Solution, Ltd., Seoul 07335 (KR)
(72) Inventor: KIM, Dong Seon, Daejeon 34122 (KR)
(74) Representative: Plasseraud IP
(86) International application number: PCT/KR2022/014016
(87) International publication number: WO 2023/063604

(56) References cited:
- JP-A- 2013 051 839
- JP-A- 2020 171 142
- JP-B2- 5 351 872
- JP-B2- 5 762 699
- KR-A- 20200 116 983
- KR-B1- 100 894 021

## Description

### [TECHNICAL FIELD]

### TECHNICAL FIELD

Embodiments disclosed herein relate to a battery control system and method for guiding a state of charge (SoC) level.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium ion battery is attracting attention as a next-generation energy storage medium as a usage range thereof is expanded to a power source of electric vehicles.

The document JP 2013 051839 A provides an example of operation of a rechargeable battery. It relates to a battery control system in which, through a user interface, battery SoC maximum and SoC minimum values are recommended to a user for maximizing charge/discharge energy rates.

### [DISCLOSURE]

### [TECHNICAL PROBLEM]

Due to limitation of a lifespan (a state of health (SoH)) of a battery, various studies are being discussed to extend the lifespan of the battery or maximize the efficiency of the battery. In particular, a state of charge (SoC) indicating a charge/discharge state of the battery has an influence upon the lifespan of the battery, and thus a solution for guiding a user to efficiently manage the SoC is required.

Technical problems of the embodiments disclosed herein are not limited to the above-described technical problems, and other unmentioned technical problems would be clearly understood by one of ordinary skill in the art from the following description.

### [TECHNICAL SOLUTION]

According to the present invention, a battery control system according to claim 1, and an operating method according to claim 6 are provided.

### [ADVANTAGEOUS EFFECTS]

A battery control system according to an embodiment disclosed herein may maximize SoH efficiency and extend the lifespan of the battery through efficient management of the SoC.

The battery control system according to an embodiment disclosed herein may determine in real time the SoC capable of maximizing discharge energy efficiency, based on an SoC use pattern.

### [DESCRIPTION OF DRAWINGS]

FIG. 1 is a block diagram of a general battery pack including a battery management apparatus according to various embodiments.
FIG. 2 is a block diagram showing a configuration of a battery control system according to various embodiments.
FIG. 3 is a graph showing discharge energy information according to various embodiments.
FIG. 4 is an operation flowchart of outputting a first user interface, according to various embodiments.
FIG. 5 shows a first user interface according to various embodiments.
FIG. 6 is an operation flowchart of outputting a second user interface, according to various embodiments.
FIG. 7 shows a second user interface according to various embodiments.
FIG. 8 is a graph showing updated discharge energy information according to various embodiments.
FIG. 9 is a block diagram showing a computing system that performs a battery management method, according to various embodiments.

### [MODE FOR INVENTION]

Hereinafter, various embodiments disclosed herein will be described in detail with reference to the accompanying drawings. In this document, identical reference numerals will be used for identical components in the drawings, and the identical components will not be redundantly described.

For various embodiments disclosed herein, specific structural or functional descriptions are only exemplified for the purpose of describing the embodiments, and various embodiments disclosed herein may be implemented in various forms, and should not be construed as being limited to the embodiments described herein.

As used in various embodiments, the terms "1st, "2nd", "first", "second", or the like may modify various components regardless of importance, and do not limit the components. For example, a first component may be named as a second component without departing from the right scope of an embodiment disclosed herein, and similarly, the second component may be named as the first component.

Terms used in the present document are used for only describing a specific exemplary embodiment of the disclosure and may not have an intention to limit the scope of other exemplary embodiments of the disclosure. It is to be understood that the singular forms include plural references unless the context clearly dictates otherwise.

All terms including technical and scientific terms used herein have the same meaning as commonly understood by one of ordinary skill in the art to which the embodiments disclosed herein belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In some cases, the terms defined herein may be interpreted to exclude embodiments disclosed herein.

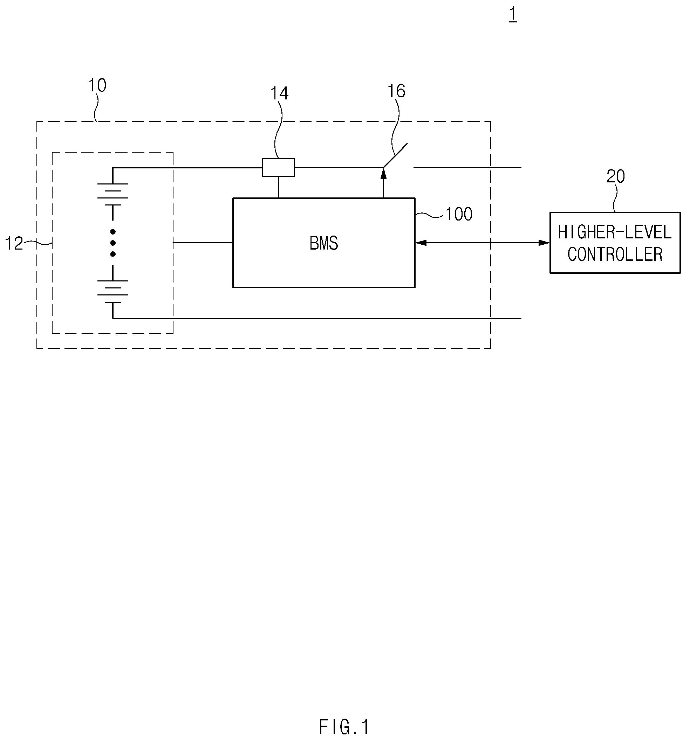

FIG. 1 is a block diagram of a general battery pack including a battery management apparatus according to various embodiments.

More specifically, FIG. 1 schematically shows a battery control system 1 including a battery pack 10 and a higher-level controller 20 included in a higher-level system according to an embodiment disclosed herein.

As shown in FIG. 1, the battery pack 10 may include a plurality of battery modules 12, a sensor 14, a switching unit 16, and a battery management system 100. The battery pack 10 may include the battery module 12, the sensor 14, the switching unit 16, and the battery management system 100 provided in plural.

The plurality of battery modules 12 may include at least one chargeable/dischargeable battery cells. In this case, the plurality of battery modules 12 may be connected in series or in parallel.

The sensor 14 may detect current flowing in the battery pack 10. In this case, a detected signal may be transmitted to the battery management system 100.

The switching unit 16 may be connected in series to a (+) terminal side or a (-) terminal side of the battery module 12 to control the charging/discharging current flow of the battery module 12. For example, the switching unit 16 may use at least one relay, a magnetic contactor, etc., according to the specifications of the battery pack 10.

The battery management system 100 may monitor the voltage, current, temperature, etc., of the battery pack 10 to perform control and management to prevent overcharging and overdischarging, etc., and may include, for example, an RBMS.

The battery management system 100, which is an interface for receiving measurement values of the above-described various parameter values, may include a plurality of terminals and a circuit, etc., connected thereto to process input values. The battery management system 100 may control on/off of the switching unit 16, e.g., a relay, a contactor, etc., and may be connected to the battery module 12 to monitor the state of each battery module 12.

The higher-level controller 20 may transmit a control signal for controlling the battery module 12 to the battery management system 100. Thus, the battery management system 100 may be controlled in terms of an operation thereof based on a signal applied from the higher-level controller 20. Also, the battery module 12 may be a component included in an energy storage system (ESS). In this case, the higher-level controller 20 may be a controller of a battery bank (BBMS) including the plurality of packs 10 or an ESS controller for controlling the entire ESS including a plurality of banks. However, the battery pack 10 is not limited to such a purpose.

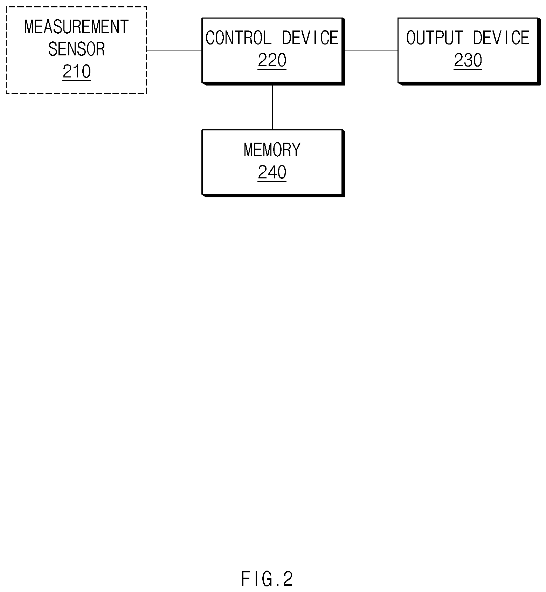

FIG. 2 is a block diagram showing a configuration of a battery control system according to various embodiments.

Referring to FIG. 2, the battery control system 1 may include a control device 220, an output device 230, and a memory 240. According to an embodiment, the battery control system 1 may further include a measurement sensor 210.

The measurement sensor 210 may monitor data about the battery in real time. For example, the measurement sensor 210 may be an on-board diagnostics (OBD). The measurement sensor 210 may measure a state of charge (SoC) of the battery in real time. The battery control system 1 may obtain a charge/discharge pattern of the battery based on data measured through the measurement sensor 210.

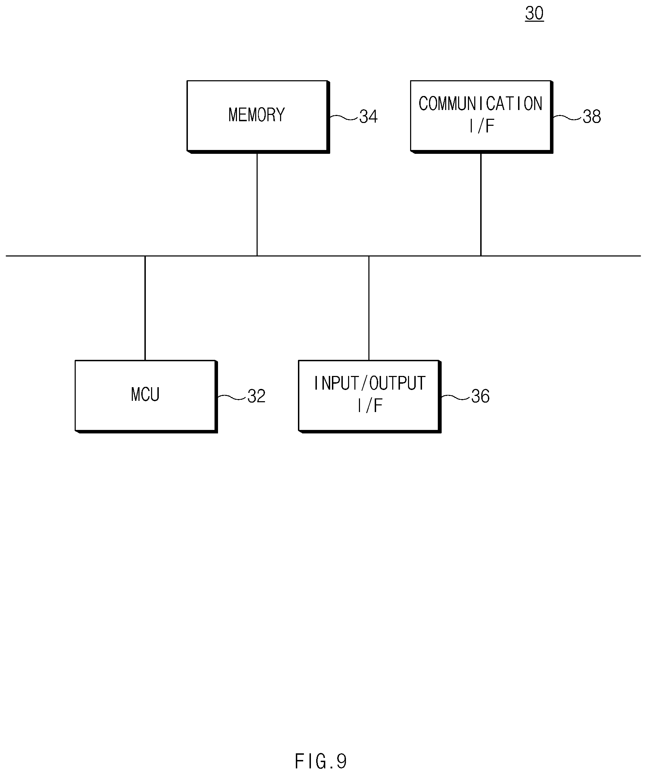

The output device 230 may output a user interface (UI) for guiding an SoC level or battery charge. In this case, the output device 230 may include at least one of a display for outputting a graphic user interface (GUI), a speaker for outputting sounds, or a haptic module for outputting vibration. According to an embodiment, the output device 230 may further include an input interface (e.g., a touch circuit or a microphone of a display) capable of receiving a user input. In this case, the output device 230 may include the same configuration as an input/output I/F 36 of FIG. 9 or a corresponding configuration.

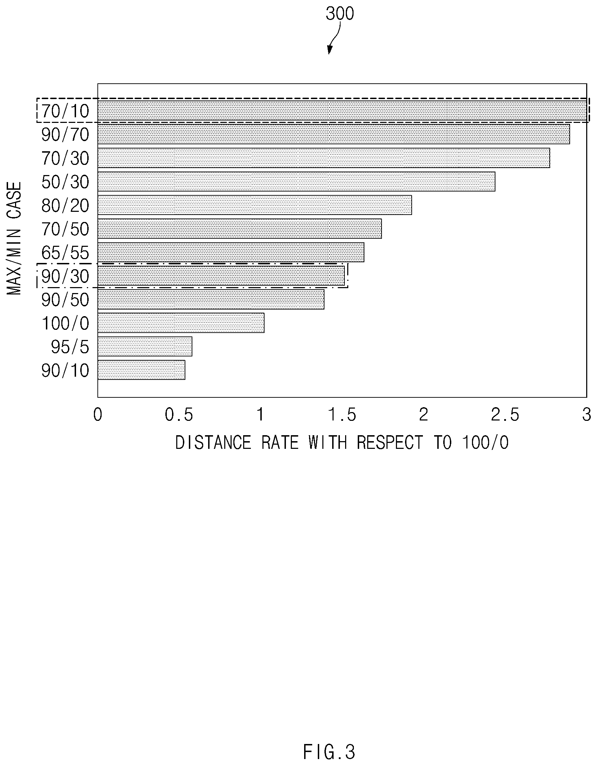

The memory 240 may include one or more of a volatile memory or a non-volatile memory. The volatile memory may include a dynamic random access memory (DRAM), a static RAM (SRAM), a synchronous DRAM (SDRAM), a phase-change RAM (PRAM), a magnetic RAM (MRAM), a resistive RAM (RRAM), a ferroelectric RAM (FeRAM), etc. The non-volatile memory may include a read-only memory (ROM), a programmable ROM (PROM), an electrically programmable ROM (EPROM), an electrically erasable programmable ROM (EEPROM), a flash memory, etc. The memory 240 may further include a non-volatile medium such as a hard disk drive (HDD), a solid state disk (SSD), an embedded multi-media card (eMMC), a universal flash storage (UFS), etc. The memory 240 may store an instruction controlled by the battery control system 1, a control instruction code, control data, or user data. For example, the memory 240 may include at least one of an application program, an operating system (OS), middleware, or a device driver. The memory 240 may store discharge energy information with respect to an SoC maximum value (or a maximum level) or an SoC minimum value (or a minimum level), as shown in FIG. 3. The battery control system 1 may guide the SoC maximum level and minimum level capable of maximizing the lifespan of the battery to the user through the discharge energy information.

The control device 220 may include the same configuration as the battery management system 100 of FIG. 1 or a corresponding configuration. In another example, the control device 220 may include the same configuration as an MCU 32 of FIG. 9 or a corresponding configuration. In various embodiments, the control device 220 may include a single processor core or a plurality of processor cores. For example, the control device 220 may include a multi-core such as a dual-core, a quad-core, a hexa-core, etc. According to embodiments, the control device 220 may further include a cache memory located inside or outside. According to embodiments, the control device 220 may be configured with one or more processors. For example, the control device 220 may include at least one of an application processor, a communication processor, or a graphical processing unit (GPU). The entire control device 220 or a part thereof may be electrically or operably or operatively coupled with or connected to other components in the battery control system 1 (e.g., the output device 230, the memory 240, or the measurement sensor 210). The control device 220 may receive a command of other components of the battery control system 1, interpret the received command, and perform calculation or process data according to the interpreted command. The control device 220 may process data or a signal created or generated in a program. For example, the control device 220 may request an instruction, data, or a signal to a memory (not shown) to execute or control the program.

The control device 220 according to an embodiment may perform the overall operation of the battery control system 1. For example, the control device 220 may determine the SoC minimum value and the SoC minimum value in which discharge energy is maximum, based on the discharge energy information stored in the memory, and output the user interface through the output device 230 to guide the determined SoC values. In another example, when battery charge is detected, the control device 220 may monitor whether a charge SoC reaches the SoC maximum value, and terminate the battery charge when the charge SoC reaches the SoC maximum value. Alternatively, the control device 220 may output a user interface indicating that the charge SoC reaches the SoC maximum value, through the output device 230. In another example, the control device 220 may output a user interface guiding battery charge through the output device 230 when a difference between the current SoC measured through the measurement sensor 210 and the SoC minimum value is less than a threshold value.

According to an embodiment, the control device 220 may obtain an SoC pattern corresponding to charge and discharge through the measurement sensor 210 and update discharge energy information previously stored in the memory 240 based on the obtained SoC pattern. In this case, the battery control system 1 may further include a learning unit (or a learning processor) for performing machine learning. The learning unit may learn data (i.e., an SoC pattern and corresponding discharge energy information) through an artificial neural network model and store the learned data and a learning history. The artificial neural network model may be stored in a space allocated to the memory 240. The space allocated to the memory 240 may store the learned model by dividing the same into a plurality of versions according to a learning time, a learning progress, etc. The control device 220 may analyze and learn a discharge energy change amount with respect to the SoC pattern by using the learning unit, and modify current discharge energy information based on learned information. In this case, the SoC maximum value and the SoC minimum value in which a discharge energy is maximum may be changed. The learning unit may improve data analysis and machine learning algorithms and performance accuracy based on the updated information.

FIG. 3 is a graph showing discharge energy information according to various embodiments.

Referring to FIG. 3, a vertical axis indicates a maximum/minimum SoC value (or level) and a horizontal axis indicates a discharge cumulative energy rate with respect to an SoC maximum/minimum value. For example, a discharge cumulative energy rate of 3 for an SoC maximum/minimum value of 70/10 may be twice a discharge cumulative energy rate of 1.5 for an SoC maximum/minimum value of 90/30. The discharge cumulative energy rate increases with the battery lifespan efficiency, such that the battery control system 1 may guide the SoC maximum/minimum value (i.e., 70/10) for the maximum discharge cumulative energy rate to the user.

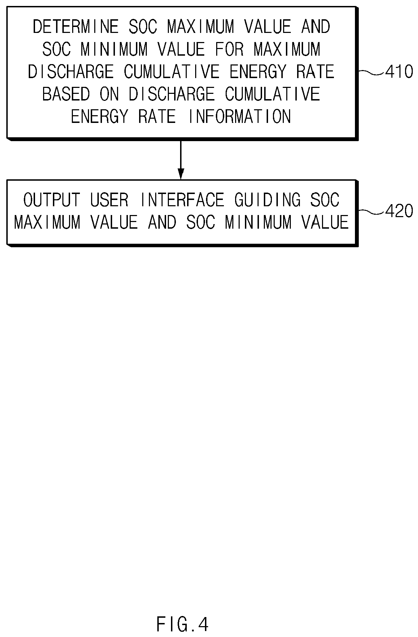

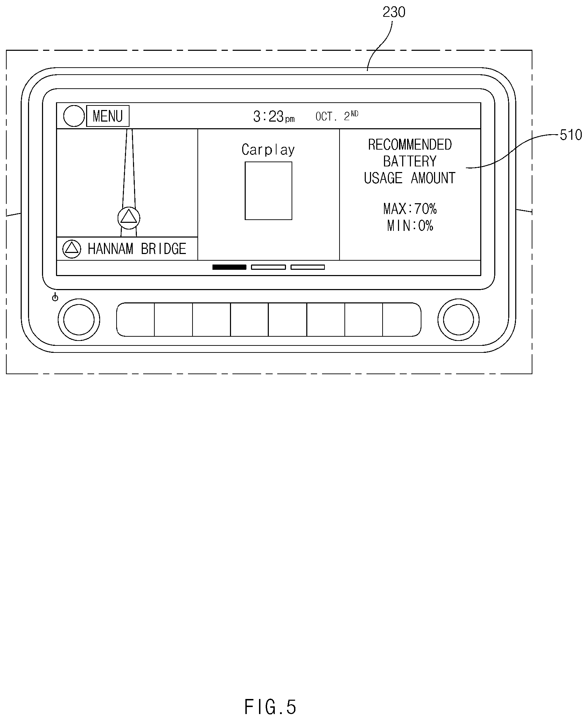

FIGS. 4 and 5 describe outputting a first user interface according to various embodiments. Herein, the 'first user interface' may mean a user interface indicating an SoC maximum value and an SoC minimum value for the maximum discharge energy (or discharge cumulative energy rate). FIG. 4 shows an operation flowchart for outputting the first user interface, and FIG. 5 shows the first user interface. In the following description, operations included in the operation flowchart may be implemented by the battery control system 1 or a component thereof (e.g., the control device 220).

Referring to FIG. 4, in operation 410, the battery control system 1 may determine an SoC maximum value and an SoC minimum value for the maximum discharge cumulative energy rate based on discharge cumulative energy rate information (or discharge energy information). According to an embodiment, the discharge energy information may be data determined by an SoC charge and discharge experiment of the battery. In another example, the discharge energy information may be data determined by a battery usage pattern (or a charge and discharge pattern). For example, the battery control system 1 may obtain a battery usage pattern according to driving of a vehicle and charge of a battery, and determine the SoC maximum value and the SoC minimum value for the maximum discharge cumulative energy rate.

In operation 420, the battery control system 1 may output the first user interface guiding the determined SoC maximum value and SoC minimum value. For example, referring to FIG. 5, the battery control system 1 may output a GUI 510 indicating a recommended battery usage amount through the output device 230 (e.g., an AV system or a navigation). In another example, the battery control system 1 may guide the SoC maximum value and the SoC minimum value through voice.

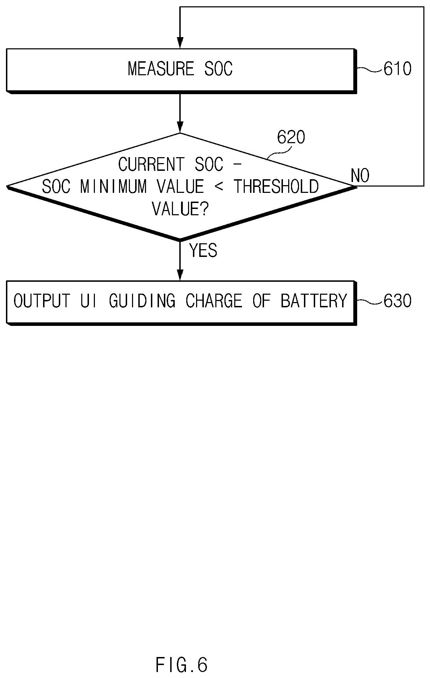

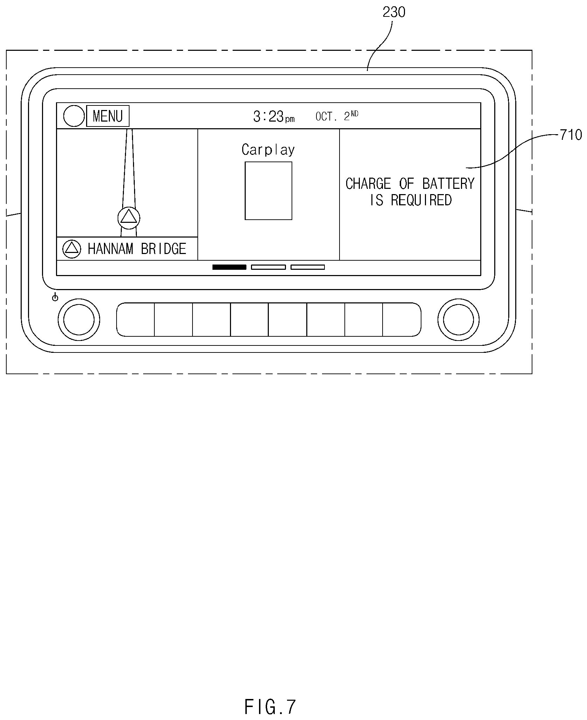

FIGS. 6 and 7 describe outputting a second user interface according to various embodiments. Herein, the 'second user interface' may mean a user interface guiding charge of a battery. FIG. 6 shows an operation flowchart for outputting the second user interface, and FIG. 7 shows the second user interface.

Referring to FIG. 6, in operation 610, the battery control system 1 may measure an SoC of the battery. For example, the control device 220 may obtain the SoC through the measurement sensor 210. In this case, the measurement sensor 210 may measure the SoC in every designated periods or measure the SoC at every specific events (e.g., upon start or end of charge of the battery, upon end of driving of the vehicle, upon on/off of ignition).

In operation 620, the battery control system 1 may identify whether a difference between the current SoC and the SoC minimum value determined based on the discharge energy information is less than a threshold value. When the difference is not less than the threshold value, the battery control system 1 may repeat operations 610 and 620.

When the difference is less than the threshold value, in operation 630, the battery control system 1 may output a UI guiding charge of the battery. For example, referring to FIG. 7, the battery control system 1 may output a GUI 710 guiding charge of the battery through the output device 230. In another example, the battery control system 1 may guide charge of the battery through voice.

On a principle similar with FIGS. 6 and 7, when a battery charge SoC reaches the SoC maximum value determined based on the discharge energy information or a difference between the battery charge SoC and the SoC maximum value is less than a threshold value, the battery control system 1 may output a user interface guiding termination of charge of the battery. For example, the control device 220 may identify the SoC through the measurement sensor 210 during charge of the battery upon detecting charge of the battery, and output a user interface when the identified SoC (i.e., the battery charge SoC) reaches the SoC maximum value. In this case, the control device 220 may terminate charge of the battery without a user input.

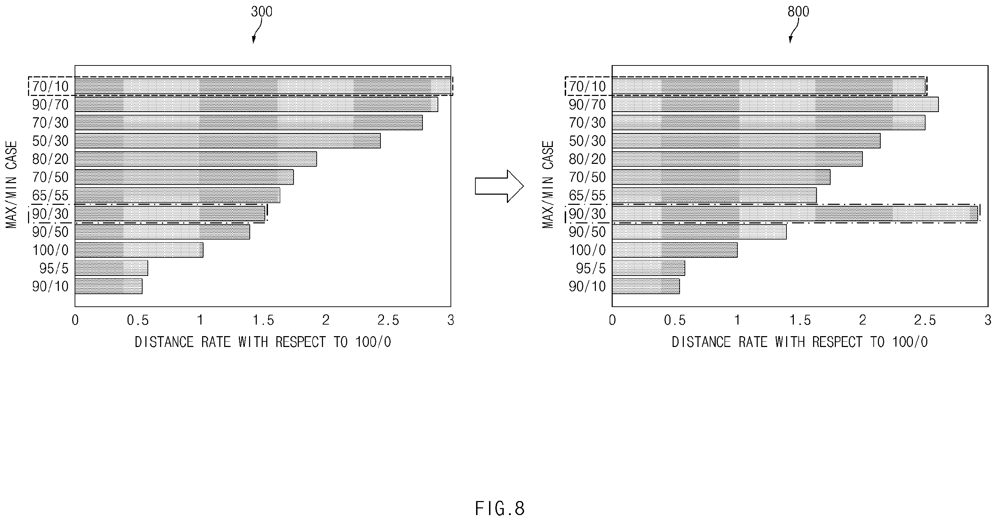

FIG. 8 is a graph showing updated discharge energy information according to various embodiments.

When charge and discharge of the battery are repeated, deterioration of the battery progresses, such that the accuracy of discharge cumulative energy rate information with respect to the SoC maximum value and the SoC minimum value may degrade. The battery control system 1 according to an embodiment may update discharge energy information by training a battery usage pattern in previously stored experiment data (i.e., initial discharge energy information). The control device 220 (or the learning unit) may calculate optimal SoC maximum value and SoC minimum value with respect to a battery usage pattern by applying a supervised learning algorithm to the previously stored experiment data. For example, as shown in FIG. 8, when existing discharge energy information 300 is updated into new discharge energy information 800 through data learning, the control device 220 may change the SoC maximum/minimum value for the maximum discharge cumulative energy rate.

FIG. 9 is a block diagram showing a computing system that performs a battery management method, according to various embodiments.

Referring to FIG. 9, a computing system 30 according to an embodiment disclosed herein may include an MCU 32, a memory 34, an input/output I/F 36, and a communication I/F 38.

The MCU 32 may be a processor that executes various programs (e.g., a feature calculation program, a class classification and lifespan estimation program, etc.) stored in the memory 34, processes various data including voltage, current, etc., of a battery cell through these programs, and executes the above-described functions of the battery management apparatus shown in FIG. 1.

The memory 34 may store various programs regarding feature calculation, class classification, and lifespan estimation of the battery cell. Moreover, the memory 34 may store various data such as a voltage, a current, feature data, etc., of each battery cell.

The memory 34 may be provided in plural, depending on a need. The memory 34 may be volatile memory or non-volatile memory. For the memory 34 as the volatile memory, random access memory (RAM), dynamic RAM (DRAM), static RAM (SRAM), etc., may be used. For the memory 34 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 34 are merely examples and are not limited thereto.

The input/output I/F 36 may provide an interface for transmitting and receiving data by connecting an input device (not shown) such as a keyboard, a mouse, a touch panel, etc., and an output device such as a display (not shown), etc., to the MCU 32.

The communication I/F 38, which is a component capable of transmitting and receiving various data to and from a server, may be various devices capable of supporting wired or wireless communication. For example, a program for feature calculation, class classification, and lifespan estimation for a battery cell or various data, etc., may be transmitted and received to and from a separately provided external server through the communication I/F 38.

As such, a computer program according to an embodiment disclosed herein may be recorded in the memory 34 and processed by the MCU 32, thus being implemented as a module that performs functions shown in FIG. 1 or 2.

Even though all components constituting an embodiment disclosed herein have been described above as being combined into one or operating in combination, the embodiments disclosed herein are not necessarily limited to the embodiments. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present document.

## Claims

1. A battery control system (1) comprising:
an output device (230);
a memory (240) configured to store discharge energy information with respect to a maximum value and a minimum value of a state of charge (SoC); and
a control device (220) connected with the output device and the memory,
wherein the control device is configured to:
determine an SoC maximum value and an SoC minimum value for a maximum discharge cumulative energy rate, based on the discharge energy information; and
output a user interface, UI, for guiding a user through the SoC maximum value and the SoC minimum value through the output device,
further comprising a measurement sensor configured to measure an SoC in real time,
wherein the control device is further configured to output, through the output device, a UI guiding the user through the charge of the battery when a difference between a current SoC measured through the measurement sensor and the SoC minimum value is less than a threshold value,
wherein the control device is further configured to:
obtain an SoC pattern with respect to charge and discharge through the measurement sensor; and
update the SoC maximum value and the SoC minimum value for the maximum discharge cumulative energy rate based on the SoC pattern.

2. The battery control system of claim 1, wherein the control device is further configured to:
detect charge of a battery; and
output, through the output device, a UI indicating end of the charge of the battery or indicating that a charge SoC reaches the SoC maximum value, when the charge SoC reaches the SoC maximum value during the charge of the battery.

3. The battery control system of claim 1, wherein the control device comprises a battery management system (BMS), and
the measurement sensor comprises an on-board diagnostics (OBD) device.

4. The battery control system of claim 1, further comprising a learning unit configured to learn an SoC pattern and corresponding discharge energy information through an artificial neural network model and store the learned data and a learning history in a space allocated to the memory.

5. The battery control system of claim 4, wherein the control device analyzes and learns a discharge energy change amount with respect to the SoC pattern by using the learning unit, an d modifies current discharge energy information based on learned information.

6. An operating method of a battery control system, the operating method comprising:
determining a state of charge (SoC) maximum value and an SoC minimum value for a maximum discharge cumulative energy rate, based on discharge energy information stored in a memory; and
outputting a user interface (UI) for guiding a user the SoC maximum value and the SoC minimum value through an output device,
further comprising:
measuring a current SoC through a measurement sensor; and
outputting, through the output device, a UI guiding the user the charge of the battery when a difference between the current SoC measured through the measurement sensor and the SoC minimum value is less than a threshold value
obtaining an SoC pattern with respect to charge and discharge through the measurement sensor; and
updating the SoC maximum value and the SoC minimum value for the maximum discharge cumulative energy rate based on the SoC pattern.

7. The operating method of claim 6, further comprising:
detecting charge of a battery; and
outputting, through the output device, a UI indicating end of the charge of the battery or indicating that a charge SoC reaches the SoC maximum value, when the charge SoC reaches the SoC maximum value during the charge of the battery.

8. The operating method of claim 6, wherein the control device comprises a battery management system (BMS), and
the measurement sensor comprises an on-board diagnostics (OBD) device.

9. The operating method of claim 6, further comprising learning by a learning unit an SoC pattern and corresponding discharge energy information through an artificial neural network model and storing the learned data and a learning history in a space allocated to the memory.

10. The operating method of claim 9, wherein analyzing by the control device and learning a discharge energy change amount with respect to the SoC pattern by using the learning unit, and modifying current discharge energy information based on learned information.

## Patentansprüche

1. Batteriesteuerungssystem (1), umfassend:
eine Ausgabevorrichtung (230);
einen Speicher (240), der konfiguriert ist, um Entladeenergieinformationen in Bezug auf einen Maximalwert und einen Minimalwert eines Ladezustands (SoC) zu speichern; und
eine Steuervorrichtung (220), die mit der Ausgabevorrichtung und dem Speicher verbunden ist,
wobei die Steuervorrichtung konfiguriert ist zum:
Bestimmen eines SoC-Maximalwerts und eines SoC-Minimalwerts für eine maximale kumulative Entladeenergierate basierend auf den Entladeenergieinformationen; und
Ausgeben einer Benutzeroberfläche, UI, über die Ausgabevorrichtung, um einen Benutzer durch SoC-Maximalwert und den SoC-Minimalwert zu führen,
ferner umfassend einen Messsensor, der konfiguriert ist, um einen SoC in Echtzeit zu messen,
wobei die Steuervorrichtung ferner konfiguriert ist, um über die Ausgabevorrichtung eine UI auszugeben, die den Benutzer durch das Laden der Batterie führt, wenn eine Differenz zwischen einem aktuellen SoC, der durch den Messsensor gemessen wird, und dem SoC-Minimalwert kleiner als ein Schwellenwert ist,
wobei die Steuervorrichtung ferner konfiguriert ist zum:
Erhalten eines SoC-Musters in Bezug auf das Laden und Entladen durch den Messsensor; und
Aktualisieren des SoC-Maximalwerts und des SoC-Minimalwerts für die maximale kumulative Entladeenergierate basierend auf dem SoC-Muster.

2. Batteriesteuerungssystem nach Anspruch 1, wobei die Steuervorrichtung ferner konfiguriert ist zum:
Erfassen der Ladung einer Batterie; und
Ausgeben, durch die Ausgabevorrichtung, einer UI, die das Ende der Ladung der Batterie anzeigt oder anzeigt, dass ein Lade-SoC den SoC-Maximalwert erreicht, wenn der Lade-SoC während der Ladung der Batterie den SoC-Maximalwert erreicht.

3. Batteriesteuerungssystem nach Anspruch 1, wobei die Steuervorrichtung ein Batteriemanagementsystem (BMS) umfasst, und
der Messsensor eine On-Board-Diagnose(OBD)-Vorrichtung umfasst.

4. Batteriesteuerungssystem nach Anspruch 1, ferner umfassend eine Lerneinheit, die konfiguriert ist, um ein SoC-Muster und entsprechende Entladeenergieinformationen durch ein künstliches neuronales Netzwerkmodell zu lernen und die gelernten Daten und eine Lernhistorie in einem dem Speicher zugewiesenen Bereich zu speichern.

5. Batteriesteuerungssystem nach Anspruch 4, wobei die Steuervorrichtung einen Entladeenergie-Änderungsbetrag in Bezug auf das SoC-Muster unter Verwendung der Lerneinheit analysiert und lernt und aktuelle Entladeenergieinformationen basierend auf gelernten Informationen modifiziert.

6. Betriebsverfahren eines Batteriesteuerungssystems, wobei das Betriebsverfahren umfasst:
Bestimmen eines Maximalwerts des Ladezustands (SoC) und eines Minimalwerts des SoC für eine maximale kumulative Entladeenergierate basierend auf in einem Speicher gespeicherten Entladeenergieinformationen; und
Ausgeben einer Benutzeroberfläche (UI) über eine Ausgabevorrichtung, um einen Benutzer durch SoC-Maximalwert und den SoC-Minimalwert zu führen,
ferner umfassend:
Messen eines aktuellen SoC durch einen Messsensor; und
Ausgeben, über die Ausgabevorrichtung, einer UI, die den Benutzer durch das Laden der Batterie führt, wenn eine Differenz zwischen dem aktuellen SoC, der durch den Messsensor gemessen wird, und dem SoC-Minimalwert kleiner als ein Schwellenwert ist;
Erhalten eines SoC-Musters in Bezug auf das Laden und Entladen durch den Messsensor; und
Aktualisieren des SoC-Maximalwerts und des SoC-Minimalwerts für die maximale kumulative Entladeenergierate basierend auf dem SoC-Muster.

7. Betriebsverfahren nach Anspruch 6, ferner umfassend:
Erfassen der Ladung einer Batterie; und
Ausgeben, durch die Ausgabevorrichtung, einer UI, die das Ende der Ladung der Batterie anzeigt oder anzeigt, dass ein Lade-SoC den SoC-Maximalwert erreicht, wenn der Lade-SoC während der Ladung der Batterie den SoC-Maximalwert erreicht.

8. Betriebsverfahren nach Anspruch 6, wobei die Steuervorrichtung ein Batteriemanagementsystem (BMS) umfasst, und
der Messsensor eine On-Board-Diagnose(OBD)-Vorrichtung umfasst.

9. Betriebsverfahren nach Anspruch 6, ferner umfassend das Lernen, durch eine Lerneinheit, eines SoC-Musters und entsprechender Entladeenergieinformationen durch ein künstliches neuronales Netzwerkmodell und das Speichern der gelernten Daten und einer Lernhistorie in einem dem Speicher zugewiesenen Bereich.

10. Betriebsverfahren nach Anspruch 9, bei dem durch die Steuervorrichtung ein Entladeenergie-Änderungsbetrag in Bezug auf das SoC-Muster unter Verwendung der Lerneinheit analysiert und gelernt wird und aktuelle Entladeenergieinformationen basierend auf gelernten Informationen modifiziert werden.

## Revendications

1. Système de commande de batterie (1) comprenant :
un dispositif de sortie (230) ;
une mémoire (240) configurée pour stocker des informations d'énergie de décharge par rapport à une valeur maximale et une valeur minimale d'un état de charge (SoC) ; et
un dispositif de commande (220) connecté au dispositif de sortie et à la mémoire,
dans lequel le dispositif de commande est configuré pour :
déterminer une valeur maximale de SoC et une valeur minimale de SoC pour un taux d'énergie cumulée de décharge maximal, sur la base des informations d'énergie de décharge ; et
délivrer en sortie une interface utilisateur, Ul, pour guider un utilisateur concernant la valeur maximale de SoC et la valeur minimale de SoC par l'intermédiaire du dispositif de sortie,
comprenant en outre un capteur de mesure configuré pour mesurer un SoC en temps réel,
dans lequel le dispositif de commande est en outre configuré pour délivrer en sortie, par l'intermédiaire du dispositif de sortie, une UI guidant l'utilisateur concernant la charge de la batterie lorsqu'une différence entre un SoC actuel mesuré par l'intermédiaire du capteur de mesure et la valeur minimale de SoC est inférieure à une valeur de seuil,
dans lequel le dispositif de commande est en outre configuré pour :
obtenir un profil de SoC par rapport à la charge et à la décharge par l'intermédiaire du capteur de mesure ; et
mettre à jour la valeur maximale de SoC et la valeur minimale de SoC pour le taux d'énergie cumulée de décharge maximal sur la base du profil de SoC.

2. Le système de commande de batterie selon la revendication 1, dans lequel le dispositif de commande est en outre configuré pour :
détecter la charge d'une batterie ; et
délivrer en sortie, par l'intermédiaire du dispositif de sortie, une UI indiquant la fin de la charge de la batterie ou indiquant qu'un SoC de charge atteint la valeur maximale de SoC, lorsque le SoC de charge atteint la valeur maximale de SoC pendant la charge de la batterie.

3. Le système de commande de batterie selon la revendication 1, dans lequel le dispositif de commande comprend un système de gestion de batterie (BMS), et
le capteur de mesure comprend un dispositif de diagnostic embarqué (OBD).

4. Le système de commande de batterie selon la revendication 1, comprenant en outre une unité d'apprentissage configurée pour apprendre un profil de SoC et des informations d'énergie de décharge correspondantes par l'intermédiaire d'un modèle de réseau neuronal artificiel et pour stocker les données apprises et un historique d'apprentissage dans un espace alloué à la mémoire.

5. Le système de commande de batterie selon la revendication 4, dans lequel le dispositif de commande analyse et apprend une quantité de changement d'énergie de décharge par rapport au profil de SoC en utilisant l'unité d'apprentissage, et modifie les informations d'énergie de décharge actuelles sur la base des informations apprises.

6. Procédé de fonctionnement d'un système de commande de batterie, le procédé de fonctionnement comprenant :
la détermination d'une valeur maximale d'état de charge (SoC) et d'une valeur minimale de SoC pour un taux d'énergie cumulée de décharge maximal, sur la base d'informations d'énergie de décharge stockées dans une mémoire ; et
la sortie d'une interface utilisateur (UI) pour guider un utilisateur concernant la valeur maximale de SoC et la valeur minimale de SoC par l'intermédiaire d'un dispositif de sortie,
comprenant en outre :
la mesure d'un SoC actuel par l'intermédiaire d'un capteur de mesure ; et
la sortie, par l'intermédiaire du dispositif de sortie, d'une UI guidant l'utilisateur pour la charge de la batterie lorsqu'une différence entre le SoC actuel mesuré par l'intermédiaire du capteur de mesure et la valeur minimale de SoC est inférieure à une valeur de seuil l'obtention d'un profil de SoC par rapport à la charge et à la décharge par l'intermédiaire du capteur de mesure ; et
la mise à jour de la valeur maximale de SoC et de la valeur minimale de SoC pour le taux d'énergie cumulée de décharge maximal sur la base du profil de SoC.

7. Le procédé de fonctionnement selon la revendication 6, comprenant en outre :
la détection de la charge d'une batterie ; et
la sortie, par l'intermédiaire du dispositif de sortie, d'une UI indiquant la fin de la charge de la batterie ou indiquant qu'un SoC de charge atteint la valeur maximale de SoC, lorsque le SoC de charge atteint la valeur maximale de SoC pendant la charge de la batterie.

8. Le procédé de fonctionnement selon la revendication 6, dans lequel le dispositif de commande comprend un système de gestion de batterie (BMS), et
le capteur de mesure comprend un dispositif de diagnostic embarqué (OBD).

9. Le procédé de fonctionnement selon la revendication 6, comprenant en outre l'apprentissage par une unité d'apprentissage d'un profil de SoC et d'informations d'énergie de décharge correspondantes par l'intermédiaire d'un modèle de réseau neuronal artificiel et le stockage des données apprises et d'un historique d'apprentissage dans un espace alloué à la mémoire.

10. Le procédé de fonctionnement selon la revendication 9, comprenant l'analyse par le dispositif de commande et l'apprentissage d'une quantité de changement d'énergie de décharge par rapport au profil de SoC en utilisant l'unité d'apprentissage, et la modification des informations d'énergie de décharge actuelles sur la base des informations apprises.
